(19) **Europäisches Patentamt**
**European Patent Office**
**Office européen des brevets**

(11) Numéro de publication: **0 241 086**
**B1**

(12) **FASCICULE DE BREVET EUROPEEN**

(45) Date de publication du fascicule du brevet: **23.01.91**

(51) Int. Cl.⁵: **H 03 J 3/32**, G 06 F 11/20

(21) Numéro de dépôt: **87200596.2**

(22) Date de dépôt: **31.03.87**

(54) **Dispositif comportant des circuits accordés sur des fréquences données.**

(30) Priorité: **08.04.86 FR 8604980**

(43) Date de publication de la demande:
**14.10.87 Bulletin 87/42**

(45) Mention de la délivrance du brevet:
**23.01.91 Bulletin 91/04**

(84) Etats contractants désignés:
**DE FR GB IT**

(56) Documents cités:
**EP-A-0 147 518      FR-A-2 149 396**
**EP-A-0 155 728      US-A-3 714 637**

**1985 IEEE INTERNATIONAL CONFERENCE ON CONSUMER ELECTRONICS, 5 juin 1985, pages 78,79, IEEE, New York, US; D. DUMONT et al.: "Computer controlled television channel selection and tuner alignment"**

**IBM TECHNICAL DISCLOSURE BULLETIN, vol. 27, no. 11, avril 1985, pages 6393,6394, New York, US; "Partially good chip part number reduction by dynamic relocation"**

(73) Titulaire: **PHILIPS COMPOSANTS**
**117, quai du Président Roosevelt**
**F-92130 Issy les Moulineaux (FR)**
(84) **FR**

(73) Titulaire: **N.V. Philips' Gloeilampenfabrieken**
**Groenewoudseweg 1**
**NL-5621 BA Eindhoven (NL)**
(84) **DE GB IT**

(72) Inventeur: **Dumont, Daniel**
**Societe Civile S.P.I.D. 209 rue de l'Université**
**F-75007 Paris (FR)**

(74) Mandataire: **Jacquard, Philippe et al**
**Société Civile S.P.I.D. 156, Boulevard Haussmann**
**F-75008 Paris (FR)**

EP 0 241 086 B1

Courier Press, Leamington Spa, England.

**Description**

La présente invention a pour objet un dispositif comportant des circuits accordés sur des fréquences données pouvant être sélectionnées et dans lequel des données numériques d'alignement correspondant à chacune desdites fréquences sont stockées dans une mémoire programmable (PROM) associée auxdits circuits, et comportant un circuit logique de sélection de fréquence propre à faire correspondre à chaque fréquence les données numériques correspondantes, le mémoire programmable comporte pour chaque fréquence une ligne d'écriture.

Un tel dispositif est connu de l'article de Daniel DUMONT et Arno NEELEN intitulé "Computer Controlled Television Channel Selection and Tuner Alignment" paru dans le compte rendu IEEE International Conference on Consumer Electronics June 5, 1985 pp. 78—79.

Selon cet article, le tuner d'un récepteur de télévision est aligné une fois pour toutes en usine à l'aide d'un ordinateur. Les données numériques d'alignement qui sont stockées dans la mémoire programmable consistent pour chaque fréquence en les valeurs d'alimentation de trois diodes Varicap faisant partie de trois circuits accordés de manière corrélée à celle d'un oscillateur local. Pour chaque canal de télévision, on mémorise donc un jeu de trois tensions de diodes Varicap. De la sorte, on gagne un temps important par rapport à la technique classique d'alignement manuel, consistant à ajuster une à une les selfs des circuits accordés, mais aux prix toutefois d'un inconvénient.

En effet, si pour au moins une des fréquences d'alignement, l'écriture dans la mémoire programmable est défectueuse, ne serait ce que pour une des tensions de diode Varicap d'une seule des fréquences, alors le tuner est inutilisable, ce qui conduit à un rejet lors du contrôle de fabrication.

L'invention a pour objet un dispositif ne présentant pas ces inconvénients et qui peut être utilisé même si des écritures défectueuses ont été inscrites dans la mémoire programmable.

Le dispositif selon l'invention est dans ce but caractérisé en ce que chaque ligne d'écriture comprend un élément d'information d'écriture indiquant si l'écriture dans ladite ligne est correcte ou non, en ce que les écritures dans les lignes sont organisées séquentiellement en correspondance avec un ordre donné des fréquences, en ce que, pour toute ligne d'écriture défectueuse, les données numériques d'alignement sont réinscrites dans la ligne suivante et en ce que le circuit logique de sélection de fréquence comporte:

un registre tampon recevant un premier compte correspondant à une fréquence sélectionnée,

un compteur/décompteur cadencé par un premier signal d'horloge jusqu'à ce qu'il ait atteint un deuxième compte fixé une fois pour toutes,

un registre à décalage cadencé par ledit premier signal d'horloge et agencé de manière que ses sorties adressent séquentiellement ligne par ligne la mémoire programmable,

un première porte logique identifiant que le compteur/décompteur a atteint ledit deuxième compte et dont la sortie verrouille dans ce cas ledit premier signal d'horloge,

et un circuit logique de détection dudit élément d'information d'écriture, dont la sortie est agencée pour faire reculer d'un pas le compteur/décompteur dans le cas où ledit élément d'information correspond à une ligne d'écriture défectueuse, de telle sorte que, pour un premier compte correspondant à la $k^{ième}$ fréquence, le registre à décalage reste dans une position où il adresse la $k^{ième}$ ligne valablement écrite de la mémoire programmable, après avoir balayé séquentiellement les (k-1) premières lignes valablement écrites et le cas échéant les lignes dont l'écriture est défectueuse.

Le registre tampon peut recevoir, en synchronisme avec ledit premier compte, un signal d'autorisation de chargement, lequel autorise le passage d'une impulsion du signal d'une deuxième horloge de même période que la première, mais décalée dans le temps par rapport à celle-ci, vers l'entrée de cadencement d'une bascule de type D, dont l'entrée reçoit du registre tampon un signal représentatif du chargement effectif du premier compte, dont la sortie, lorsqu'elle est à son état haut, déverrouille le premier signal d'horloge, et qui est remise à zéro par la sortie de la première porte logique.

Selon un mode préféré, le registre à décalage est remis à zéro par ledit signal d'autorisation de chargement et reçoit à son entrée ledit signal représentatif du chargement effectif du premier compte dans le registre tampon. Le dispositif peut également comporter une deuxième porte logique recevant la sortie du circuit logique de détection ainsi que le signal d'une troisième horloge de même période que la première, mais décalée dans le temps par rapport à celli-ci, de manière à synchroniser le compteur/décompteur lorsqu'il recule d'un pas.

L'invention sera mieux comprise à la lecture de la description qui va suivre, donnée à titre d'exemple non limitatif, en liaison avec les dessins qui représentent:

la figure 1, la mémoire programmable ainsi que la détection de ligne défectueuse associée;

et la figure 2, la partie logique du dispositif selon l'invention, la figure 3 représentant la chronologique des signaux caractéristiques de son fonctionnement.

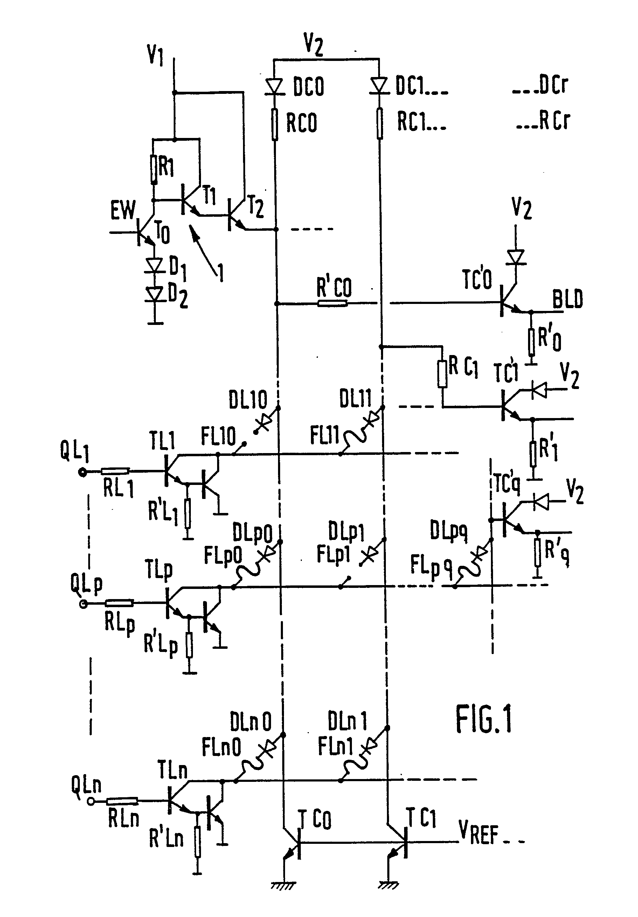

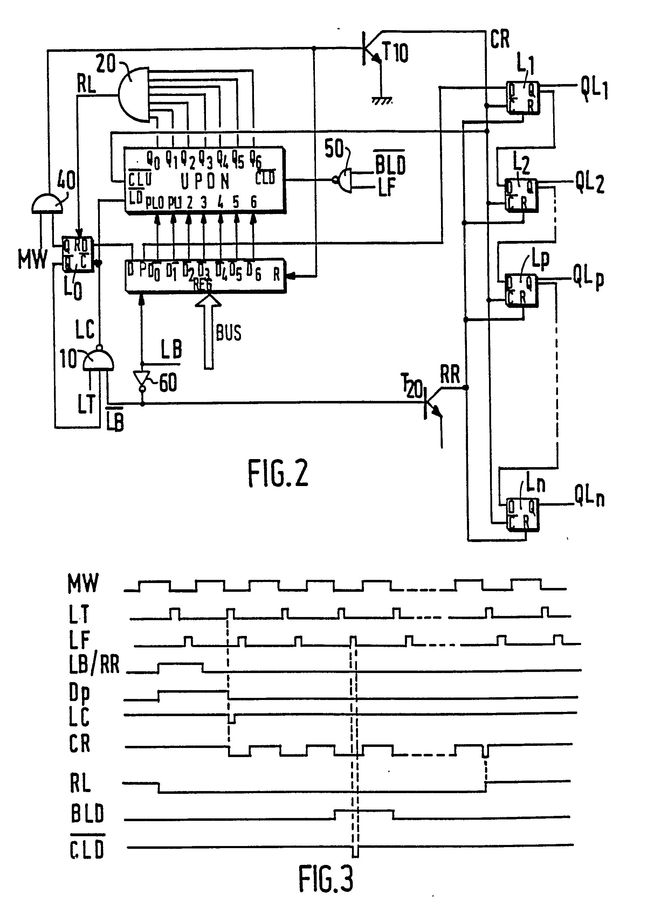

La figure 1 montre l'organisation d'une mémoire programmable permettant de mettre en oeuvre l'invention. L'inscription dans celle-ci est organisé ligne par ligne et pour chaque ligne, on consacre la colonne No 0 à la mémorisation de l'état l'inscription de celle-ci. En d'autre termes, la colonne no 0 de la mémoire est réservée à la validation des informations mémorisées. On réalise un test préalable de la mémoire non écrite. Ensuite, pour écrire une ligne, on affiche sur le tuner à régler une fréquence donnée et une séquence de fréquences déterminée à l'avance et on réalise de la manière décrite dans l'article précité la détermination et la mémorisation de trois tensions caractéristiques de diodes Varicap. On mémorise ces trois tensions dans les colonnes 1 à r de la mémoire, par exemple en utilisant des mots de 5 bits pour chaque valeur de tenson et une mémoire comportant des lignes de 16 bits. On test ensuite les information inscrites dans la ligne correspondante et si celles-ci sont bonnes, on valide le ligne en faisant fondre le fusible correspondant de la colonne no 0. Si les informations testées sont erronées, on opère une réinscription dans la ligne suivante et on teste de nouveau les informations en vue de la validation de cette ligne écrite. Cette opération peut se répéter autant de fois que des lignes mauvaises sont détectées. Lorsqu'une ligne est validée, on procède dans la ligne suivante à l'opération d'inscription et de validation de la fréquence suivant de la séquence. A titre d'exemple, pour l'inscription d'une séquence de 80 canaux, on peut prendre une mémoire de 100 lignes de 16 bits, ce qui laisse une marge de sécurité très large étant donné que les lignes d'écritures mauvaises sont en pratique peu fréquentes. Plus spécifiquement, la mémoire programmable à n lignes et r colonnes comporte pour chaque colonne, 0, 1 . . . r un circuit d'écriture alimenté sous une tension $V_1$ de l'ordre de 12 V, donc de valeur suffisante pour que les fusibles des lignes sélectionnés fondent lorsque le Darlington constitué par les transistors $T_1$ et $T_2$ est rendu conducteur sous l'action d'un signal d'autorisation d'écriture EW appliqué à la base d'un transistor $T_0$. Chacune des colonnes est alimentée à une tension $V_2$ de l'ordre de 5V, donc de valeur permettant la lecture des lignes sélectionnées de la mémoire. Chaque colonne 0, 1 . . . , q, . . . r comporte successivement à patir de l'extrémité alimentée à la tension d'alimentation $V_2$ une diode $DC_0$, $DC_1$, . . . $DC_q$ . . . $DC_r$, une résistance $RC_0$, $RC_1$, . . . $RC_q$ . . . $RC_r$, et n montages en série d'une diode DL et d'un fusible FL pontant la colonne et respectivement chacune des lignes. Entre la colonne de rang q et la ligne de rang p, la diode correspondante a pour référence DLpq et le fusible correspondant, la référence FLpq. Pour fixer le niveau haut, une chute de tension est produite pour chaque colonne par une source de courant constituée par un transistor TC0, . . . TCq . . . TCr dont la base est portée à une tension de référence $V_{REF}$. Chaque ligne est sélectionnable par un circuit Darlington, référencé TLp, R'Lp l'alimenté par un signal de sélection de ligne QLp à travers une résistance RLp. La lecture de chaque colonne est réalisée pour la colonne de rang q, par un transistor TC'q monté en émetteur suiveur et dont la base est connectée à la colonne correspondante à travers une résistance R'CO et dont l'émetteur est relié à la masse à travers une résistance R'q. Lorsque la ligne p est sélectionnée, le Darlington TLp est conducteur, et le transistor TC'q de la colonne q est bloqué et donc sa sortie est au niveau bas si le fusible FLpq est présent. Si le fusible FLpq a été fondu, le transistor TC'q est passant, et donc sa sortie est au niveau haut. Tous les éléments décrits ci-dessus sont propres au fonctionnement classique des mémoires programmables. Le point spécifique de l'invention est que la colonne de rang 0 est réservée à la validation de l'information mémorisée dans les n lignes. Ainsi qu'il a été dit plus haut, toute sélection de ligne se traduit par la fusion du fusible correspondant de la colonne 0. Lorsqu'une telle ligne est sélectionnée, le transistor TC0 est conducteur et le signal $\overline{BLD}$ qu'il fournit sur son émetteur est au niveau bas. Par contre, lorsqu'une ligne mauvaise (ou tout simplement non écrite est sélectionnée), le signal $\overline{BLD}$ est au niveau haut et fournit une indication au circuit logique de sélection de fréquence qui va être décrit maintenant en se reportant aux figures 2 et 3.

Le circuit logique de sélection de fréquence reçoit des données d'entrée fournies par le bus d'un miroprocesseur ainsi qu'un signal LB d'autorisation de chargement de ces données dans un registre tampon REG. Les données d'entrée et le signal d'autorisation LB sont susceptibles d'intervenir à tout moment car elles correspondent à un ordre de chargement d'une fréquence, donné par l'utilisateur du tuner.

Le circuit logique génère trois signaux d'horloge de même fréquence, le premier MW sous forme de signaux carrés, et les deux autres, successivement LT et LF sous forme d'impulsions s'inscrivant dans l'intervalle où le signal MW est au niveau bas.

Le circuit logique présente un compteur-décompteur UPDN présentant une entrée de chargement $\overline{LD}$ active sur un front descendant de signal pour recevoir les données d'entrées stockées dans le registre tampon REG, à l'exception d'une donnée DP indicative de la présence des données d'entrée.

Le compteur-décompteur UPDN présente une entrée de comptage $\overline{CLU}$ et une entrée de décomptage $\overline{CLD}$ actives sur un front descendant de signal. Une bascule $L_0$ de type D reçoit à son entrée D la donnée DP, à son entrée de cadencement $\overline{C}$, active sur un front descendant de signal le signal LC produit à la sortie d'une porte ET inverseuse 10 dont les entrées reçoivent le signal d'horloge interne LT, le signal $\overline{LB}$, présent à la sortie d'un inverseur 60 ainsi que le signal de sortie inversé $\overline{Q}$ de la bascule $L_0$, et à son entrée de remise à zéro R un signal RL produit à la sortie d'une porte multiple 20 de décodage, par exemple une porte ET dont les entrées reçoivent les sorties $Q_0$ . . . $Q_6$ du compteur/décompteur, de manière à remettre à zéro la bascule $L_0$ lorsque le compteur-décompteur UPDN a atteint un compte donné. La sortie non inverseuse Q de la bascule $L_0$ est introduite à l'une des deux entrées d'une porte ET 40 dont l'autre entrée reçoit le signal d'horloge MW.

La sortie de la porte ET 40 attaque d'une part l'entrée R de remise à zéro du registre tampon R et la base d'un transistor $T_{10}$ dont l'émetteur est à la masse et dont le collecteur produit un signal CR qui sert à cadencer un registre à décalage présentant n bascule $L_1 \ldots L_n$ de type D en cascade, c'està-dire que la sortie Q de la bascule de rang p attaque l'entrée D de la bascule de rang p+1 pour tout p compris entre 1 et n-1, et que le signal CR attaque l'entrée de cadencement $\bar{C}$, active sur un front descendant de signal, de chacune des bascules $L_1 \ldots L_n$. L'entrée D de la première bascule $L_1$ reçoit le signal DP indiquant la présence d'information dans le registre tampon REG. Les vascules $L_1 \ldots L_n$ sont remises à zéro par un signal RR issu du signal LB. A cet effet, le signal LB est appliqué à l'entrée d'un inverseur 60 dont l'entrée attaque la base d'un transistor $T_{20}$ dont l'émetteur est à la masse et dont le collecteur est connecté aux entrées de remise à zéro R des bascules $L_1 \ldots L_n$. Les signaux disponibles aux sorties Q des registres $L_1 \ldots L_n$ sont respectivement les signaux $QL_1 \ldots QL_n$ appliqués aux entrées de sélection de ligne de la mémoire programmable (cf fig. 1).

On va maintenant décrire une opération de sélection d'une fréquence. Le BUS envoie dans le registre tampon REG un signal de huits bits ainsi que le signal LB d'autorisation de chargement. Aux sorties inverseuses $\bar{D_0}, \bar{D_1} \ldots \bar{D_6}$ du registre REG, sont présentes les inverses logiques de chacun des bits d'information d'adresse. La présence du signal LB haut, et donc de $\overline{LB} = 0$ à l'entrée de la porte 10, inhibe le passage de LT. Dès que LB = 0, et comme le registre $L_0$ a sa sortie Q à zéro ($\bar{Q} = 1$), la première impulsion du signal LT qui, rappelons le, intervient lorsque le signal MW est un niveau bas porte au niveau bas le signal LC. Les entrées $PL_0, PL_1 \ldots PL_6$ du compteur UPDN sont alors chargées par le complément logique des bits d'information envoyés par le BUS. Le signal DP met au niveau haut la sortie Q de la bascule $L_0$ dès que LC est au niveau bas, c'est-à-dire en même temps que le compteur UPDN est chargé. La sortie Q de la bascule $L_0$ autorise alors le passage du signal $\overline{MW}$ qui remet à zéro le registre tampon REG ce qui fait notamment passer DP à zéro en même temps que le signal CR cadence l'entree $\bar{C}$ des registres $QL_1 \ldots QL_p$ du registre à décalage, et donc charge à 1 la sortie Q du registre $QL_1$, ce qui adresses la première ligne de la mémoire programmable. Le signal CR fait également avancer d'une unité le compteur UPDN (entrée $\overline{CLU}$). En outre, la sortie $\bar{Q} = 0$ de la bascule $L_0$ bloque la porte 10 et empêche tout passage des impulsions d'horloge LT.

Si la première ligne est bonne, alors $\overline{BLD}$ est au niveau bas et la sortie de la porte 50 reste au niveau haut. A chaque passage ultérieur a niveau bas du signal MW et donc de CR, le registre à décalage est cadencé, et le niveau haut présent en sortie du registre $L_1$ circule séquentiellement vers les registres $L_2, L_3 \ldots$. Si on suppose que la ligne p est défectueuse, alors un $\overline{BLD}$ de niveau haut autorisé par LF fait reculer d'une unité le registre UPDN (entrée $\overline{CLD}$). Donc, en commutant le registre pour adresser la ligne p, le compteur-décompteur UPDN avance d'une unité lorsque MW passe au niveau bas, et recule d'une unité dès qu' intervient LF, alors que MW est encore au niveau bas. Il en résulte que tout se passe comme si la ligne p n'avait pas été inscrite. La ligne de rang (p+1) dans laquelle est inscrite la $p^{ième}$ information valable est prise en compte par le compteur-décompteur comme la $p^{ième}$ ligne de la séquence. Le signal $\overline{BLD}$ reste présent pendant une période d'horloge MW, jusqu'à ce que la ligne (p+1) soit sélectionnée.

Ces opérations se poursuivent jusqu'à ce que la compteur-décompteur ait atteint un compte donné, à savoir 1111111 au cas où la porte 20 est une porte ET multiple. Dans ce cas, le signal RL en sortie de la porte 20 remet à zéro le registre $L_0$ (entrée R), dont la sortie Q bloque la pote 40 ce qui fait que la dernière ligne sélectionnée reste sélectionnée jusqu'à ce qu'apparaisse un nouveau signal LB haut remettant à zéro le registre à décalage. Les paramètres caractéristiques de la fréquence sélectionnée du tuner peuvent être pris en compte par le récepteur de la manière décrite dans la publication précitée.

**Revendications**

1. Dispositif comportant des circuits accordés sur des fréquences données pouvant être sélectionnées et dans lequel des données numériques d'alignement correspondant à chacune desdites fréquences sont stockées dans une mémoire programmable (PROM) associée auxdits circuits, et comportant un circuit logique de sélection de fréquence propre à faire correspondre à chaque fréquence les données numériques correspondantes, dans lequel la mémoire programmable comporte pour chaque fréquence une ligne d'écriture caractérisé en ce qu la ligne et écriture comprend un élément d'information d'écriture indiquant si l'écriture dans ladite ligne est correcte ou non, en ce que les écritures dans les lignes sont organisées séquentiellement en correspondance avec un ordre donné des fréquences, en ce que, pour toute ligne d'écriture défectueuse, les données numériques d'alignement sont réinscrites dans la ligne suivante et en ce que le circuit logique de sélection de fréquence comporte:

un registre tampon recevant un premier compte correspondant à une fréquence sélectionnée

un compteur/décompteur cadencé par un premier signal d'horloge jusqu'à ce qu'il ait atteint un deuxième compte fixé une fois pour toutes

un registre à décalage cadencé par ledit premier signal d'horloge et agencé de manière que ses sorties adressent séquentiellement ligne par ligne la mémoire programmable

une première porte logique identifiant que le compteur/décompteur a atteint ledit deuxième compte et dont la sortie verrouille dans ce cas ledit premier signal d'horloge

et une circuit logique de détection dudit élément d'information d'écriture, dont la sortie est agencée pour faire reculer d'un pas le compteur/décompteur dans le cas où ledit élément d'information correspond à une ligne d'écriture défectueuse, de telle sorte que, pour un premier compte correspondant à la k$^{ième}$ fréquence, le registre à décalage reste dans une position où il adresse la k$^{ième}$ ligne valablement écrite de la mèmoire programmable, après avoir balayé séquentiellement les (k-1) premières lignes valablement écrites et le cas échéant les lignes dont l'écriture est défectueuse.

2. Dipositif selon la revendication 1 caractérisé en ce que le registre tampon reçoit en synchronisme avec ledit premier compte un signal d'autorisation de chargement (LB), lequel autorise le passage d'une impulsion du signal d'une deuxième horloge (LT) de même période que la première, mais décalée dans le temps par rapport à celle-ci, vers l'entrée de cadencement d'une bascule de type D dont l'entrée reçoit du registre tampon un signal (DP) représentatif du chargement effectif du premier compte, dont la sortie, lorsqu'elle est à sont état haut déverrouille le premier signal d'horloge, et qui est remise à zéro par la sortie de la première porte logique.

3. Dipositive selon la revendication 2 caractérisé en ce que le registre à décalage est remis à zéro par ledit signal d'autorisation de chargement (LB) et reçoit à son entrée ledit signal (DP) représentatif du chargement effectif du premier compte dans le registre tampon.

4. Dispositif selon la revendication 3 caractérisé en ce qu'il comporte une deuxième porte logique recevant la sortie du circuit logique de détection ainsi que le signal d'une troisième horloge (LF) de même période que la première, mais décalée dans le temps par rapport à cell-ci, de manière à synchroniser le compteur-décompteur lorsqu'il recule d'un pas.

**Patentansprüche**

1. Schaltungsanordnung mit Schaltkreisen, die auf bestimmte zu selektierende Frequenzen abgestimmt sind, wobei in dieser Anordnung digitale Abstimmwerte, die jeder der genannten Frequenzen entsprechen, in einem den genannten Kreisen zugeordneten programmierbaren Speicher (PROM) gespeichert sind, und mit einer logischen Frequenzselektionsschaltung, die dazu geeignet ist, die entsprechenen digitalen Werte mit jeder Frequenz übereinstimmen zu lassen, wobei der progammierbare Speicher für jede Frequenz eine Schreibzeile aufweist, dadurch gekennzeichnet, daß die Schreibzeile ein Schreibinformationselement aufweist, das angibt, ob das Schreiben in die gennante Ziele einwandfrei ist oder nicht, daß die in die Zeilen engeschriebenen Informationen sequentiell organisiert sind entsprechend einer vorbestimmten Frequenzordnung, daß für jede nicht einwandfreie Schreibzeile die digitalen Abstimmdaten in die nächste Zeile eingeschrieben werden und daß die logische Frequenzselektionsschaltung die folgenden Elemente aufweist:

einen Pufferspeicher, der einen einer selektierten Frequenz entsprechende ersten Summenwert erhält,

einen Vorwärts-/Rückwärtszähler, der durch ein erstes Taktimpulssignal getaktet wird, bis er einen zweiten Festwert erreicht,

ein Schieberegister, das durch das genannte erste Taktimpulssignal getaktet und derart eingerichtet ist, daß die Ausgangswerte den programmierbaren Speicher sequentiell zeilenweise adressieren,

ein erstes logisches Gatter, das angibt, daß der Vorwärts-/Rüchwärtszähler den genannten zweiten Summenwert erreicht hat und dessen Ausgangssignal, in jenem Fall, das gennante erste Taktimpulssignal verriegelt,

une eine logische Detectionsschaltung für das genannte Schreibinformationselement, deren Ausgangssignal dazu gemeint ist, den Vorwärts-/Rückwärtszähler um einen Schritt zurückzustellen falls das genannte Informationselement einer nicht einwandfreien Schreibzeile entspricht, derart, daß für einen ersten Summenwert entsprechend der k. Frequenz das Schieberegister in einer Position bleibt, in der es die gültig eingeshrieben k. Ziele des programmierbaren Speichers adressiert, nachdem die gültig eingeschriebenen (k-1) ersten Zeilen sequentiell abgetastet worden sind und eventuell die Zeilen, deren Einschreibung nicht einwanfrei ist.

2. Anordnung nach Anspruch 1, dadurch gekennzeichnet, daß der Pufferspeicher synchron zu dem genannten ersten Summenwert ein Ladeberechtigungssignal (LB) erhält, das den Durchgang eines Impulses des Signals eines zweiten Taktimpulsgenerators (LT) mit derselben Periode wie der erste, aber gegenüber der ersten Periode zeitverschoben, berechtigt, und zwar zu dem Taktimpulseingang eines Multivibrators vom D-Typ, dessen Einang von dem Pufferspeicher ein Signal (DP) zugeführt bekommt, das für die effektive Ladung des ersten Summenwertes repräsentativ ist, dessen Ausgang, wenn dieser in dem hohen Zustand ist, das erste Taktimpulssignal entriegelt, und der durch das Ausgangssignal des ersten logischen Gatters auf Null rückgestellt wird.

3. Anordnung nach Anspruch 2, dadurch gekennzeichnet, daß das Schieberegister durch das genannte Ladeberechtigungssignal (LB) auf Null rückgestellt wird und an dem Eingang das genannte Signal (DP) erhält, das für die effektive Ladung des ersten Summenwertes in dem Pufferspeicher repräsentativ ist.

4. Anordnung nach Anspruch 3, dadurch gekennzeichnet, daß sie ein zweites logisches Gatter aufweist, das das Ausgangssignal der logischen Detektionsschaltung zugeführt bekommt, ebenso wie das Signal eines dritten Taktimpulsgenerators (LF) mit derselben Periode wie der erste, aber gegenüber derselben zeitverschoben, derart, daß der Vorwärts-/Rückwärtszähler synchronisiert wird, wenn er um einen Schritt zurückgestellt wird.

## Claims

1. A device comprising circuits tunable to given frequencies which can be selected and in which digital alignment data corresponding to each of said frequencies are stored in a programmable memory (PROM) associated with said circuits, and comprising a logic frequency selection circuit suitable for having the associated digital data correspond to each frequency, in which the programmable memory comprises a write row for each frequency, characterized in that the write row comprises a write information element indicating whether the data written in this row has been written correctly or not, in that the data written in the rows are sequentially arranged in accordance with a predetermined frequency order, in that for each defective write row the digital alignment data are written again in the subsequent row and in that the logic frequency selection circuit comprises:

a buffer register receiving a first count corresponding to a selected frequency;

an up/down counter clocked by a first clock signal until it has reached a second count fixed once and for all counts;

a shift register clocked by said first clock signal and acting such that its outputs sequentially address row by row of the programmable memory;

a first logic gate detecting whether the up/and down counter has reached said second count in which case its output blocks said first clock signal;

and a logic detection circuit of said write information element whose ouput is designed such as to decrement the up/down counter by one step in the case in which said information element corresponds to a defective write row, such that, for a first count corresponding to the $k^{th}$ frequency, the shift register remains in a position in which it addresses the validly written $k^{th}$ row of the programmable memory, after having sequentially scanned the validity written (k-1) first rows and, if necesssary, the defectively written rows.

2. A device as claimed in Claim 1, characterized in that the buffer register receives a load authorization signal (LB) in synchronism with said first count, which authorizes the passage of one pulse of a second clock signal (LT) having the same period as the first clock signal, but shifted in time relative to this first clock signal, to be applied to the clock signal input of a D-type bistable multivibrator whose input receives from the buffer register a signal (DP) which is representative of the effective load of the first count, and whose output, when it is in its high state, unlocks the first clock signal, and is reset to zero by the output signal of the first logic gate.

3. A device as claimed in Claim 2, characterized in that the shift register is reset to zero by said load authorization signal (LB) and at its input receives said signal (DP) which is representative of the effective load of the first count in the buffer register.

4. A device as claimed in Claim 3, characterized in that it includes a second logic gate which receives the output signal of the logic detection circuit and also the signal of a third clock (LF) having the same period as the first clock signal, but shifted in time relative to this first clock signal, in such a manner as to synchronize the up/down counter when it is decremented by one step.

EP 0 241 086 B1

FIG.1

FIG.2

FIG.3